# EUROPEAN PATENT APPLICATION

(11) **EP 4 722 728 A1**
(43) Date of publication of application: **08.04.2026**
(21) Application number: 25205897.9
(22) Date of filing: 30.09.2025
(51) Int. Cl.: G01N 35/00

(54) **EXAMINATION DEVICE**

(30) Priority: 02.10.2024 JP 2024173922
(71) Applicant: FUJIFILM Corporation, Tokyo 106-8620 (JP)
(72) Inventor: TANAKA, Kunihiko, Tokyo (JP); ONO, Hirotoshi, Tokyo (JP); OTA, So, Tokyo (JP); DENAWA, Tatsuyuki, Tokyo (JP)
(74) Representative: Dehns Germany Partnerschaft mbB

(57) **Abstract**

An examination device (10) that examines a specimen includes a display (12) that is disposed on a front surface of a main body (11) and a recess portion (16) that is provided in the front surface of the main body and that is capable of accommodating one end part of the display in a width direction of the main body.

## Description

### BACKGROUND OF THE INVENTION

### 1. Field of the Invention

The present disclosed technology relates to an examination device.

### 2. Description of the Related Art

An examination device that examines a specimen such as blood is known. Such an examination device is also called an analysis device, a measurement device, or the like. The examination device comprises a display for displaying various types of information related to the specimen and the examination.

WO2020/075818A describes an analysis device that has a display on a front surface of a main body. In the device disclosed in WO2020/075818A, the display is attached to an arm attached to the front surface, and a direction of the display can be inclined in a left-right direction by rotating the arm or the display.

JP2014-211401A describes an analysis device that has a display on an upper surface of a main body. In the device disclosed in JP2014-211401A, a recess portion for accommodating the display is provided in the upper surface of the main body. In the recess portion, the display is accommodated in a posture inclined in a direction in which the display rises to a front side, an angle at which the display rises is variable, and the display can further face the front side from the inclined initial accommodating posture.

### SUMMARY OF THE INVENTION

Depending on an examination device, for example, in a case where a height of the main body is higher than the line of sight of a user who performs examination work, it is not practical to provide the display on the upper surface of the main body as in the device described in JP2014-211401A, and it is necessary to dispose the display on the front surface of the main body as in the device described in WO2020/075818A.

However, in a case where the display is disposed on the front surface of the main body of the device, the amount of protrusion of the display protruding forward from the front surface of the main body is large in some cases. Since the user often performs work at a standing position facing the front surface of the main body, a large amount of protrusion of the display causes the feeling of pressure on the user.

The present disclosed technology provides an examination device that can reduce a feeling of pressure on a user even in a case where a display is disposed on a front surface of a main body.

According to an aspect of the present disclosed technology, there is provided an examination device comprising a display that is disposed on a front surface of a main body and a recess portion that is provided in the front surface of the main body and that is capable of accommodating one end part of the display in a width direction of the main body.

A displacement mechanism that displaces the display may be comprised.

The displacement mechanism may be capable of displacing the display in a state where the one end part of the display is accommodated in the recess portion.

The displacement mechanism may be capable of displacing the display to a state where an angle between a display surface of the display and a bottom surface of the recess portion is a preset angle in a range of 70° to 110°, on one end side of the recess portion in the width direction of the main body.

The displacement mechanism may be capable of displacing the display to a state where the angle is the preset angle without causing the display and the displacement mechanism to protrude from the range in the width direction of the main body.

The preset angle may include 90°.

The recess portion may be capable of accommodating at least a part of the displacement mechanism.

In the main body, a worktable that is usable in work related to examination may be provided below the display.

In the main body, a worktable that is usable in work related to examination may be provided below the display, and the displacement mechanism may be capable of retracting the display from the worktable by displacing the one end part of the display in the width direction of the main body, which is an end part on a worktable side, in a direction of being accommodated in the recess portion.

The displacement mechanism may be capable of changing a posture of the display such that a display surface of the display faces the worktable side in a state where the one end part is accommodated in the recess portion.

A position of the recess portion and a position of the worktable may partially overlap each other in the width direction of the main body.

The displacement mechanism may include an arm that has one end provided at the main body and the other end supporting a rear surface of the display.

The arm may have two or more rotation shafts.

The arm may have at least two rotation shafts extending in an up-down direction of the main body.

In the main body, a worktable that is usable in work related to examination may be provided below the display, in a display screen displayed on the display, a GUI operation section may be displayed on an end part side close to the worktable, and the recess portion may be capable of accommodating an end part of the display on a side where the GUI operation section is displayed.

The present disclosed technology can reduce the feeling of pressure on a user even in a case where the display is disposed on the front surface of the main body.

### BRIEF DESCRIPTION OF THE DRAWINGS

FIG. 1 is a perspective view showing an appearance of an examination device.
FIG. 2 is a perspective view of the examination device from another angle, showing the appearance of the examination device.
FIG. 3 is a front view of the examination device.
FIG. 4 is a diagram showing a relationship between a GUI operation section and a worktable.
FIG. 5 is a plan view of a display and the worktable.
FIG. 6 is a view showing a state where a display surface of a display faces a worktable side.
FIG. 7 is a view showing a state where the display surface of the display further faces the worktable side from the state of FIG. 6.
FIG. 8 is a perspective view showing a state where the aspect of FIG. 7 is viewed from a front.
FIG. 9 is a view showing a state where the display surface of the display faces sideways.
FIG. 10 is a perspective view showing a state where the aspect of FIG. 9 is viewed from the front.

### DESCRIPTION OF THE PREFERRED EMBODIMENTS

### First Embodiment

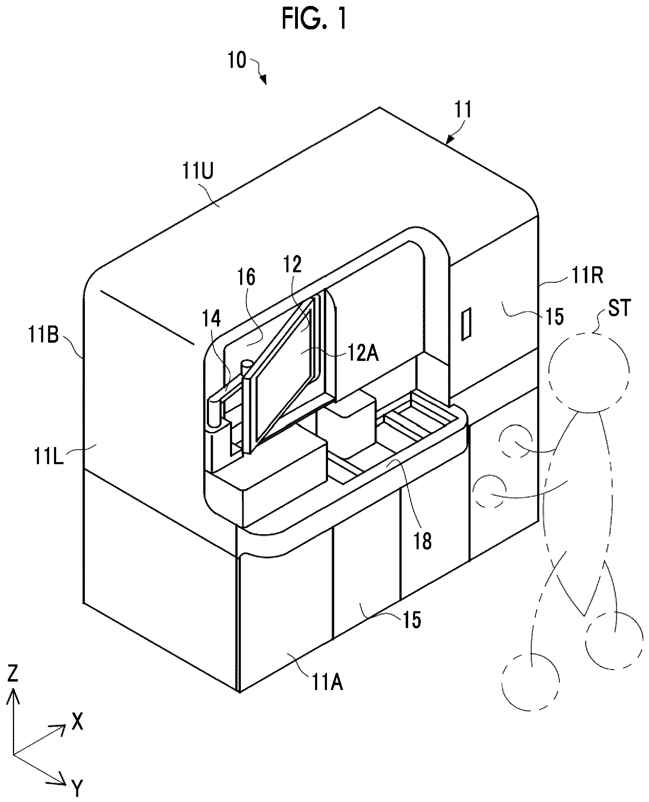

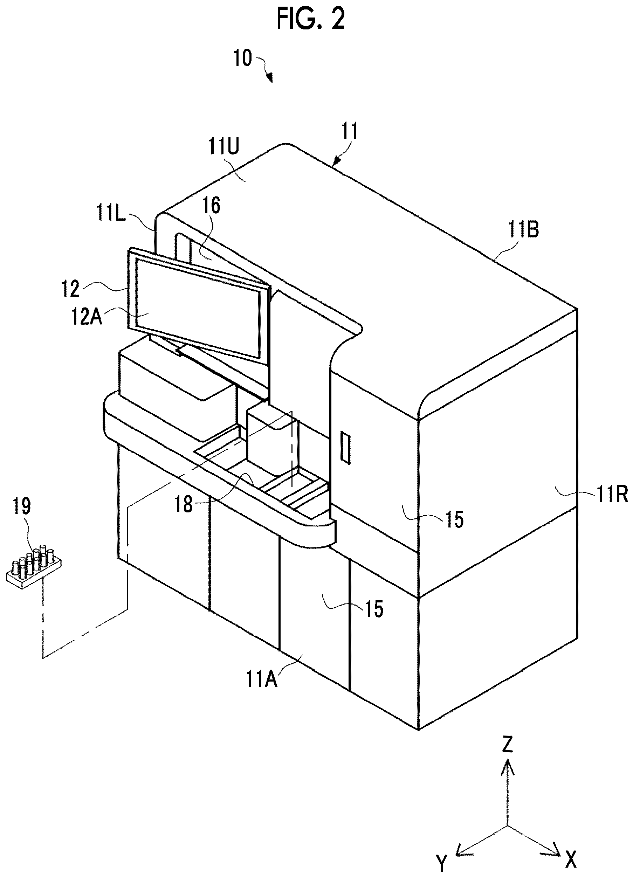

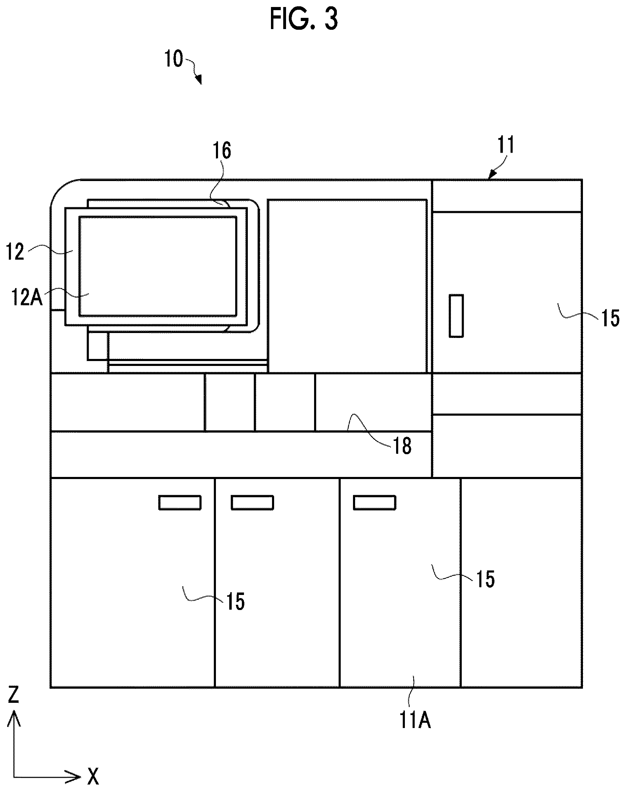

FIGS. 1 and 2 are perspective views showing an appearance of an examination device 10 according to an embodiment of the present disclosure, and FIG. 3 is a front view of the examination device 10 as viewed from a front side. The examination device 10 is an examination device that examines a specimen collected from a living body and is, for example, an immunoassay device with a chemiluminescent enzyme immunoassay as a basic principle. As is well known, the chemiluminescent enzyme immunoassay is one of an examination method for optically detecting an examination target substance by using an antigen-antibody reaction between the examination target substance in the specimen and a reagent. The specimen is, for example, a body fluid such as blood collected from the living body. The examination target substance contained in the specimen is an antigen, an antibody, a protein, a low-molecular-weight compound, and the like.

The examination device 10 comprises a main body 11 and a display 12. The main body 11 has, for example, a substantially rectangular parallelepiped shape and has a front surface 11A, a rear surface 11B, an upper surface 11U, a lower surface, and both right and left side surfaces 11R and 11L. In the coordinates shown in FIGS. 1 to 3, an X-direction is a width direction of the main body 11. The right side surface 11R is a side surface on a right side toward the front surface 11A, and the left side surface 11L is a side surface on a left side toward the front surface 11A. In addition, a Y-direction is a front-rear direction or a depth direction of the main body 11, and a Z-direction is an up-down direction or a height direction of the main body 11.

As shown in FIG. 1, a user ST who is an operator of the examination device 10, performs work related to examination including an operation of the examination device 10, for example, at a standing position facing the front surface 11A of the main body 11.

In the main body 11, for example, a specimen container in which a specimen is accommodated, a reaction container in which a reagent and a specimen are reacted with each other, and the like are loaded. In addition, the main body 11 is also provided with a storage unit that stores various types of consumables used for an examination and the like. Examples of the consumable include a single-use sampling chip used for dispensing the specimen and the reagent, various reagents, a bound (B)/free (F) separation liquid used in the process of an examination, and the like, in addition to the specimen container, the reaction container, and the like. A door 15 that can be opened and closed is provided on the front surface 11A of the main body 11, and a storage unit that stores consumables used for the examination is provided inside the door 15.

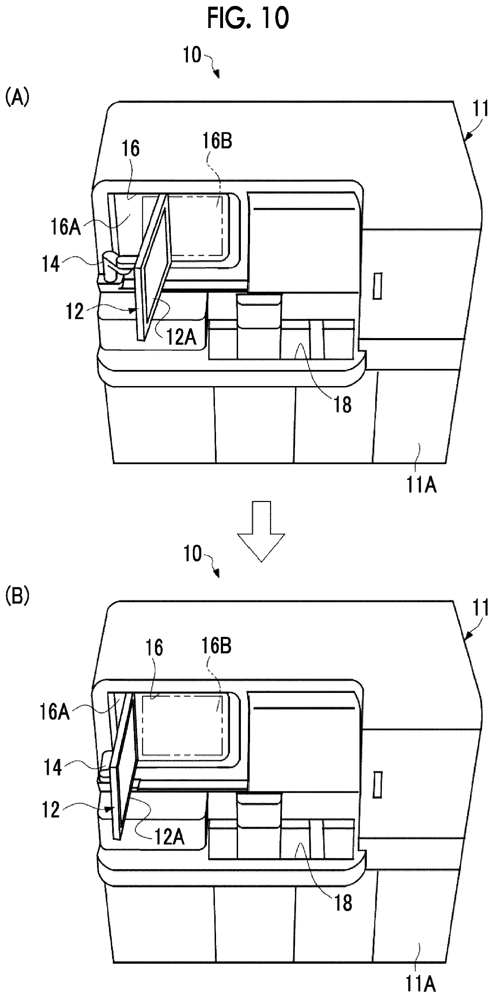

In addition, the display 12 is disposed on the front surface 11A of the main body 11. A display screen 20 (see FIG. 10) on which various types of information are displayed is displayed on a display surface 12A of the display 12. Herein, the display screen 20 is content displayed on the display 12, and the display surface 12A refers to a physical surface on which the display screen 20 is displayed on the display 12.

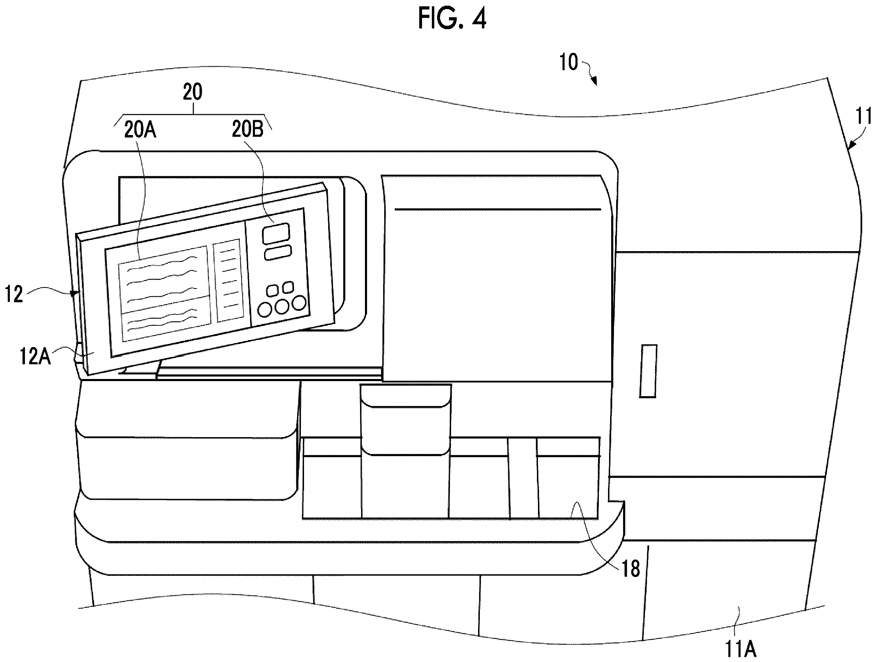

As shown in FIG. 4, the display screen 20 includes a display region 20A that displays various types of information related to an examination, such as a specimen, a measurement item, and an examination result, and a graphical user interface (GUI) operation unit 20B in which an operation button or the like for operating the main body 11 is disposed.

A displacement mechanism 14 is a mechanism that displaces the display 12. The displacement mechanism 14 can change a posture of the display 12.

In the main body 11, a worktable 18 that can be used for work related to an examination is provided below the display 12. The worktable 18 is provided, for example, substantially at a center of the front surface 11A of the main body 11 in the width direction of the main body 11. The display 12 is disposed, for example, on the left side of the center of the front surface 11A of the main body 11 in the width direction. As shown in FIG. 2, a tray 19 that can accommodate a plurality of specimen containers and the like can be placed on the worktable 18. In addition, for example, in the main body 11, a periphery of the worktable 18, for example, each portion below the worktable 18, on a back side in the depth direction, and above the worktable 18 can be opened and closed, and a specimen container or the like as an examination target is loaded therein. Since the worktable 18 is present near a place where the examination target is loaded, the user ST can efficiently perform the examination by performing work at the standing position in front of the worktable 18 as shown in FIG. 1.

The displacement mechanism 14 can change the posture of the display 12 such that the display surface 12A faces a worktable 18 side. Accordingly, since the user ST who works at the standing position in front of the worktable 18 can face the display surface 12A, it is easy to check information displayed in the display region 20A of the display screen 20 and to operate the GUI operation section 20B.

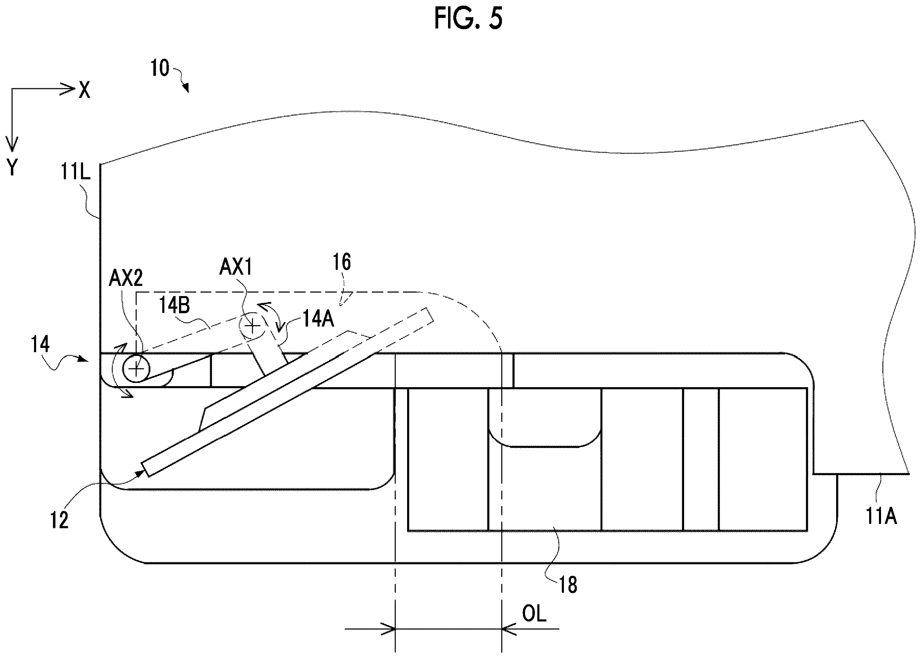

In addition, a recess portion 16 that is positioned behind the display 12 and is recessed in the depth direction (that is, the Y-direction) from a front surface 11A side is provided in the front surface 11A of the main body 11. A size of the recess portion 16 in the height direction is slightly larger than a size of the display 12 in the height direction. For this reason, the recess portion 16 can accommodate one end part of the display 12 in the width direction (that is, the X-direction) (see also a broken line portion in FIG. 5). FIGS. 1 to 4 show a state where an end part of the display 12 on the right side is accommodated in the recess portion 16. States of FIGS. 1 to 4 are a state where the display surface 12A of the display 12 faces the worktable 18 side is shown, and in this state, the end part of the display 12 on the right side, that is, a part of an end part on the worktable 18 side is accommodated in the recess portion 16. The end part of the display 12 on the right side is an end part on a side where the GUI operation section 20B is displayed. Herein, a state where an end part of the display 12 is accommodated in the recess portion 16 can also be rephrased as a state where the end part of the display 12 enters the recess portion 16.

As shown in FIG. 5, the displacement mechanism 14 comprises, for example, two arms 14A and 14B and two rotation shafts AX1 and AX2. In a case where the two arms 14A and 14B are viewed as a whole, one end of each of the two arms 14A and 14B is provided at the main body 11, and the other end thereof supports a rear surface of the display 12. Specifically, the one end of the arm 14A supports the rear surface of the display 12, and the other end is rotatably bonded to the arm 14B via the rotation shaft AX1. The arm 14B has the one end rotatably connected to the arm 14A via the rotation shaft AX1 and the other end rotatably connected to the main body 11 via the rotation shaft AX2. Both the rotation shaft AX1 and the rotation shaft AX2 are rotation shafts extending in the up-down direction (that is, the Z-direction) of the main body 11. By rotating the two arms 14A and 14B around the rotation shaft AX1 and the rotation shaft AX2, the posture of the display 12 can be changed, such as facing the display surface 12A toward the front of the main body 11 or facing the display surface 12A toward a lateral direction of the main body 11.

Although not shown, a tilt mechanism is provided at an attachment portion between the arm 14A and the display 12 in the displacement mechanism 14. The posture of the display 12 can also be changed by the tilt mechanism such that the display surface 12A faces an upper side or a lower side.

In addition, at least a part of the displacement mechanism 14 can be accommodated in the recess portion 16.

In addition, a position of the recess portion 16 and a position of the worktable 18 partially overlap each other in the width direction of the main body 11. Reference numeral OL indicates a portion where the recess portion 16 and the worktable 18 overlap each other. In the overlapping portion OL of the recess portion 16, an end part of the display 12 on the worktable 18 side can be retracted from the worktable 18 by being displaced in a direction in which the end part is accommodated in the recess portion 16.

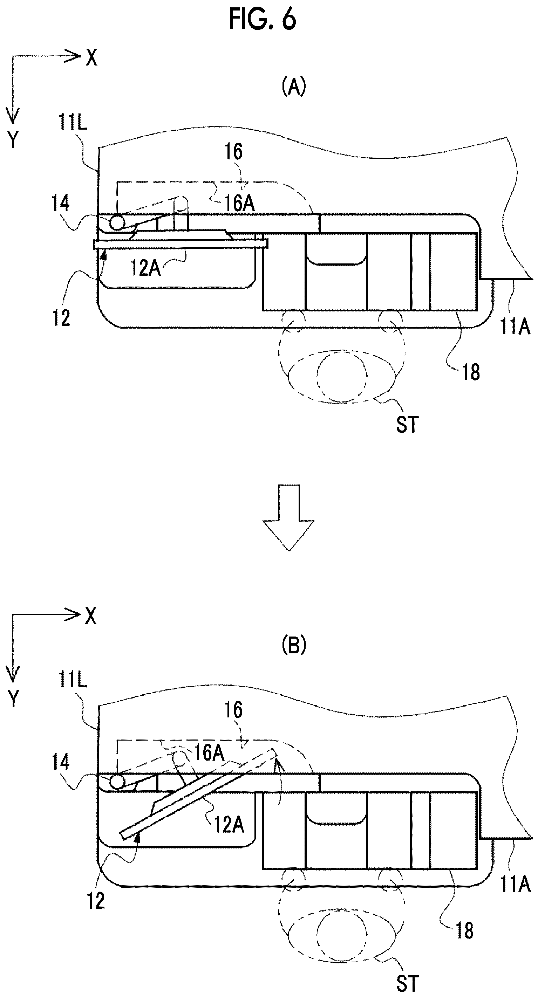

An example of a displaceable posture of the display 12 will be described with reference to FIGS. 6 to 10. First, in FIG. 6, (A) of FIG. 6 shows a posture in which the display surface 12A of the display 12 faces forward and a state where the display surface 12A is along the width direction of the main body 11. In this state, the display 12 is not accommodated in the recess portion 16, but a part of the displacement mechanism 14 is accommodated in the recess portion 16. By rotating the display 12 counterclockwise from the state of (A) of FIG. 6, the posture of the display 12 can be inclined in a direction in which the display surface 12A faces the worktable 18 side as shown in (B) of FIG. 6. In addition, in the state of (B) of FIG. 6, as indicated by a broken line, the end part of the display 12 on the right side, which is the worktable 18 side, is accommodated in the recess portion 16.

As shown in (B) of FIG. 6, the displacement mechanism 14 can retract the display 12 from the worktable 18 by displacing the end part of the display 12 on the worktable 18 side in the direction in which the end part is accommodated in the recess portion 16.

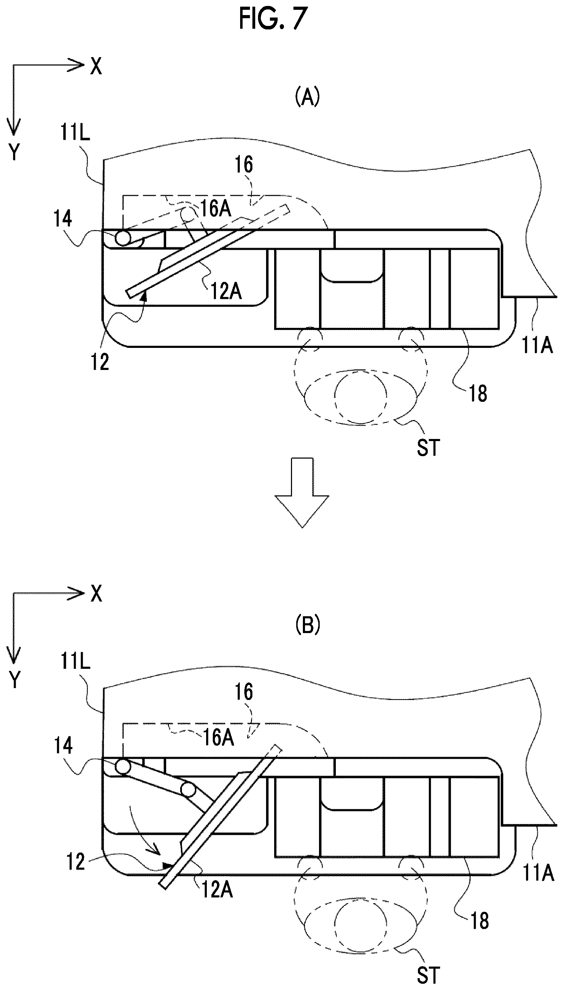

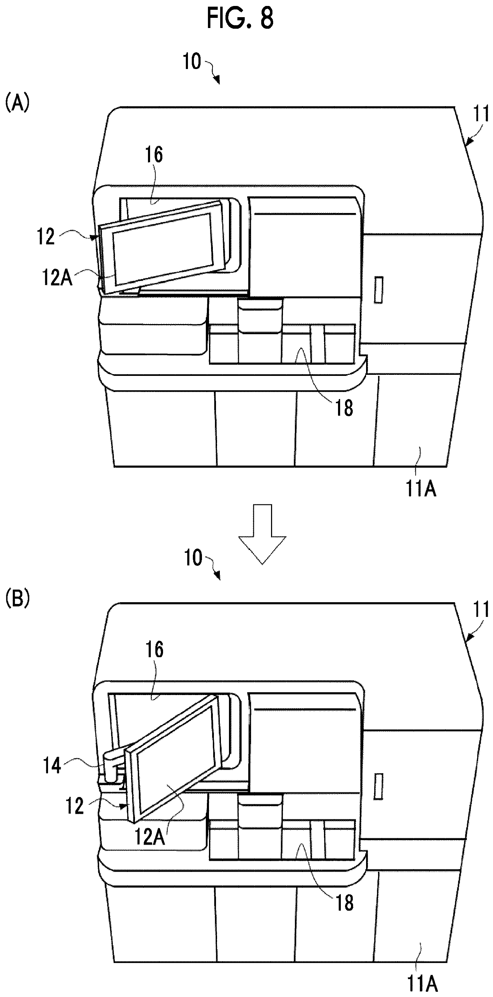

In addition, in FIG. 7, (A) of FIG. 7 shows the same state as (B) of FIG. 6, and (B) of FIG. 7 shows a state where the display surface 12A of the display 12 is further inclined to the worktable 18 side than the state of (A) of FIG. 7. In addition, FIG. 8 is a perspective view of a state corresponding to FIG. 7 as viewed from the front surface 11A side, (A) of FIG. 8 corresponds to (A) of FIG. 7, and (B) of FIG. 8 corresponds to (B) of FIG. 7.

As shown in FIG. 7, the displacement mechanism 14 can change the posture of the display 12 such that the display surface 12A of the display 12 faces the worktable 18 side in a state where the one end part of the display 12 is accommodated in the recess portion 16. In the states shown in (A) of FIG. 7 and (A) of FIG. 8, a right end part of the display 12 on the worktable 18 side is accommodated in the recess portion 16, but in the states of (B) of FIG. 7 and (B) of FIG. 8, the posture of the display 12 is changed such that the display surface 12A of the display 12 faces the worktable 18 side. The process of the posture change can be performed in a state where the right end part of the display 12 on the worktable 18 side is accommodated in the recess portion 16, for example, by rotating the arm 14A and the arm 14B in opposite directions to each other (that is, one in a clockwise direction, and the other in a counterclockwise direction).

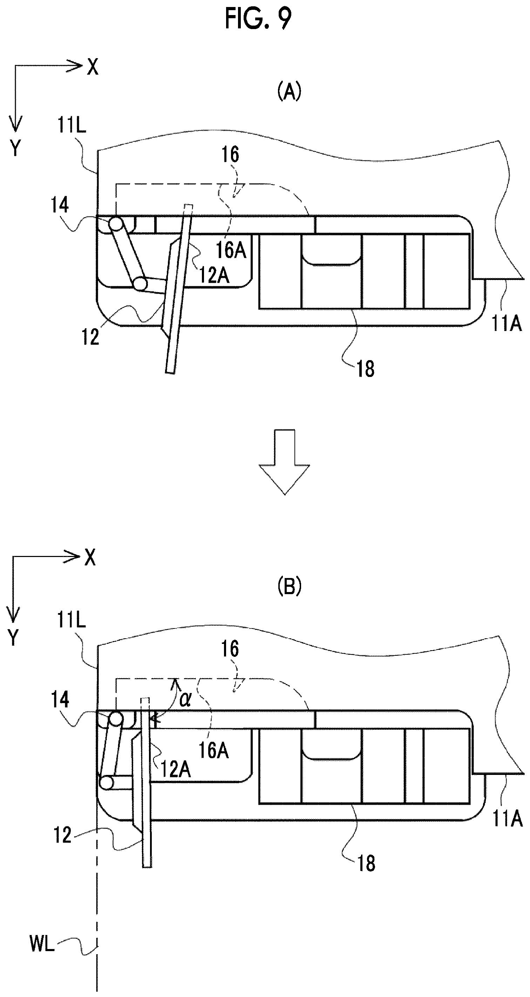

In addition, as shown in FIGS. 9 and 10, the displacement mechanism 14 can displace the display 12 to a state where an angle between the display surface 12A of the display 12 and a bottom surface 16A of the recess portion 16 is a preset angle in a range of 70° to 110°, on one end side of the recess portion 16 in the width direction of the main body 11. The preset angle includes, for example, 90°. Herein, an allowable error is included in 90°.

In FIG. 9, (A) of FIG. 9 shows a state where the display surface 12A of the display 12 is further inclined to the worktable 18 side than the state of (B) of FIG. 7, and (B) of FIG. 9 shows a state where the display surface 12A of the display 12 is further inclined to the worktable 18 side than the state of (A) of FIG. 9 and the display surface 12A and the bottom surface 16A of the recess portion 16 are substantially orthogonal to each other. That is, (B) of FIG. 9 shows a state where an angle α between the display surface 12A and the bottom surface 16A is 90°. In addition, FIG. 10 is a perspective view of a state corresponding to FIG. 9 as viewed from the front surface 11A side, (A) of FIG. 10 corresponds to (A) of FIG. 9, and(B) of FIG. 10 corresponds to (B) of FIG. 9.

As shown in FIG. 10, for example, an opening portion 16B is provided in the bottom surface 16A of the recess portion 16. The opening portion 16B is, for example, an opening portion for maintenance and is covered with an attachable and detachable lid in a case of not being used. In the state shown in (B) of FIG. 9 and (B) of FIG. 10, the display 12 is displaced to a posture in which the angle α is 90°, and the position of the display 12 is positioned on the one end side of the recess portion 16 in the width direction of the main body 11. In the example shown in (B) of FIG. 10, the display 12 is positioned on the left side of the recess portion 16. For this reason, in a case where the display 12 is in such a posture, the bottom surface 16A of the recess portion 16 hidden behind the display 12 in FIGS. 6 to 8 is exposed in the entire region including the opening portion 16B and excluding a part on the left side. Accordingly, even in a case where the opening portion 16B is present behind the display 12, it is possible to access the opening portion 16B.

In addition, as shown in (B) of FIG. 9 and (B) of FIG. 10, the displacement mechanism 14 can displace the display 12 without the display 12 and the displacement mechanism 14 protruding from a range of the main body 11 in the width direction. In (B) of FIG. 9, an imaginary line WL is an extension line from the left side surface 11L of the main body 11 and indicates the range of the main body 11 in the width direction. As described above, the display 12 can be displaced from the imaginary line WL defining a width of the main body 11 until the display 12 reaches the states shown in FIGS. 9 and 10 from the state shown in FIG. 6 via the state shown in FIGS. 7 and 8, without the display 12 and the displacement mechanism 14 protruding.

As described above, the examination device 10 according to the present disclosed technology is an examination device that examines a specimen and comprises the display 12 disposed on the front surface 11A of the main body 11 and the recess portion 16 that can accommodate the one end part of the display 12 in the width direction of the main body 11, the recess portion 16 being provided in the front surface 11A of the main body 11. Accordingly, as the one end part of the display 12 is accommodated in the recess portion 16, the display 12 can be retracted in the depth direction (that is, the Y-direction) of the main body 11 as compared with a case where there is no recess portion 16. For this reason, protrusion of the display 12 to the front side of the main body 11 is suppressed. Accordingly, the feeling of pressure given to the user ST who performs work in front of the main body 11 by the display 12 can be reduced, as compared with a case where there is no recess portion 16.

In addition, as there is the recess portion 16, a movable range of the display 12 in the depth direction is widened. Further, a suitable interval can be secured between the user ST who works at the standing position where the front surface 11A of the main body 11 and the display 12 face each other, as compared with a case where there is no recess portion 16. Accordingly, good visibility of the display 12 for the user ST can be ensured.

In addition, in the embodiment, the examination device 10 comprises the displacement mechanism 14 that displaces the display 12. The displacement mechanism 14 improves a degree of freedom of a posture change of the display 12.

In addition, in the embodiment, the displacement mechanism 14 can displace the display 12 in a state where one end part of the display 12 is accommodated in the recess portion 16. Accordingly, the posture of the display 12 can be changed while suppressing protrusion of the display 12 to the front side of the main body 11. For example, an operation of displacing the display 12 to a state where the display surface 12A is further inclined to the worktable 18 side as shown in (B) of FIG. 7 from a state where the display surface 12A is inclined to the worktable 18 side as shown in (A) of FIG. 7 can be performed in a state where the end part of the display 12 on the worktable 18 side is accommodated in the recess portion 16. Alternatively, from the states shown in FIGS. 7 and 8 to the states shown in FIGS. 9 and 10, the display 12 can be displaced in a state where the end part of the display 12 on the worktable 18 side is accommodated in the recess portion 16. Accordingly, in a case where the posture of the display 12 is changed, interference between the display 12 and the worktable 18 is suppressed.

Such a posture change of the display 12 is realized by the displacement mechanism 14 composed of, for example, the two arms 14A and 14B and the two rotation shafts AX1 and AX2. For example, in a displacement mechanism composed of one arm and one rotation shaft, since the arm can only rotate around the one rotation shaft, for example, an operation of displacing the display 12 while maintaining a certain level of interval from the bottom surface 16A of the recess portion 16 is not possible.

In addition, in the embodiment, as shown in FIGS. 9 and 10, the displacement mechanism 14 can displace the display 12 to a state where the angle between the display surface 12A of the display 12 and the bottom surface 16A of the recess portion 16 is a preset angle in a range of 70° to 110°, on the one end side of the recess portion 16 in the width direction of the main body 11. Accordingly, as shown in FIGS. 9 and 10, in a case where the opening portion 16B for maintenance or the like is provided in the bottom surface 16A of the recess portion 16 behind the display 12, it is possible to access the opening portion 16B. For example, in a case where the display 12 is disposed on the front surface 11A and a screen size of the display 12 is increased for the purpose of improving visibility, it is natural that the number of regions hidden by the display 12 on the front surface 11A increases. However, as shown in FIGS. 9 and 10, in a case where the display 12 can be displaced to a state of the preset angle in a range of 70° to 110° is reached, a region behind the display 12, which is hidden by the display 12, such as the bottom surface 16A of the recess portion 16, can be exposed, and this region can be effectively utilized.

In addition, in the embodiment, as shown in FIGS. 6 to 10, the displacement mechanism 14 can displace the display 12 to a state of the preset angle is reached, which is 70° to 110°, without the display 12 and the displacement mechanism 14 protruding from the range of the main body 11 in the width direction. Accordingly, for example, even in a case where the examination device 10 is disposed such that the left side surface 11L of the main body 11 on a side where the display 12 is provided comes into contact with a wall, the display 12 and the displacement mechanism 14 do not interfere with the wall, and the display 12 can be displaced to a state of the angle. With such a configuration, for example, even in a case where the bottom surface 16A is provided with the opening portion 16B for maintenance as shown in FIG. 10, access to the opening portion 16B is not hindered.

In addition, in the embodiment, 90° is included in the preset angle in the range of 70° to 110°. In a case where the display 12 is displaced to a state where the angle between the display surface 12A of the display 12 and the bottom surface 16A is 90°, a region of the bottom surface 16A that is hidden by the posture of the display 12, which can be effectively used can be sufficiently secured.

In addition, in the embodiment, as shown in FIGS. 5 to 7, the recess portion 16 can accommodate at least a part of the displacement mechanism 14. Accordingly, for example, in a case where the displacement mechanism 14 is disposed on a rear surface side of the display 12, a part of the displacement mechanism 14 is accommodated in the recess portion 16, and thus forward protrusion of the display 12 can be suppressed. Accordingly, the feeling of pressure given to the user ST who performs work in front of the main body 11 by the display 12 can be reduced.

In addition, in the embodiment, in the main body 11, the worktable 18 that can be used for work related to the examination is provided below the display 12, and the display 12 can be displaced in a state where the one end part of the display 12 is accommodated in the recess portion 16. Accordingly, it is easy to suppress interference between the display 12 and the worktable 18 in a case where the display 12 is displaced.

In addition, in the embodiment, the worktable 18 is provided at the main body 11, and as shown in (B) of FIG. 6 as an example, the displacement mechanism 14 can retract the display 12 from the worktable 18 by displacing the one end part of the display 12 in the width direction of the main body 11, which is the end part on the worktable 18 side, in a direction of being accommodated the recess portion 16. For this reason, interference with the work of the user ST who works in front of the worktable 18 by the display 12 can be suppressed.

Further, the displacement mechanism 14 can change the posture of the display 12 such that the display surface 12A of the display 12 faces the worktable 18 side in a state where the one end part of the display 12 is accommodated in the recess portion 16. For this reason, visibility of the display 12 can be improved for the user who performs work in front of the worktable 18.

In addition, in the embodiment, as shown in FIG. 5 and the like, the position of the recess portion 16 and the position of the worktable 18 partially overlap each other in the width direction of the main body 11. In this case, as shown in FIG. 5, since the end part of the display 12 can be accommodated in the overlapping portion OL of the recess portion 16, interference with the worktable 18 is suppressed. Accordingly, interference with the work of the user ST by the display 12 is suppressed.

In addition, in the embodiment, in a case where the two arms 14A and 14B are integrated, the displacement mechanism 14 includes an arm of which one end is provided at the main body 11 and the other end supports the rear surface of the display 12. The displacement mechanism 14 having such a configuration can increase a load resistance as compared with the displacement mechanism that supports the end part of the display 12. For this reason, the displacement mechanism 14 is advantageous in a case where the display 12 is increased in size for the purpose of improving visibility.

In addition, in the embodiment, the arms 14A and 14B have two or more rotation shafts. Specifically, as shown in FIG. 5, the displacement mechanism 14 has the two rotation shafts AX1 and AX2. In the displacement mechanism 14 having such two or more rotation shafts, a degree of freedom of a posture change of the display 12 is improved as compared with a case where the rotation shaft is one.

In addition, in the embodiment, the arms 14A and 14B have at least the two rotation shafts AX1 and AX2 extending in the up-down direction of the main body 11. Accordingly, a direction of the display surface 12A of the display 12 is easily changed in a left-right direction. In addition, as described above, by having a plurality of rotation shafts extending in the up-down direction, an operation of displacing the display 12 along the bottom surface 16A of the recess portion 16 in a state where the end part of the display 12 is accommodated in the recess portion 16 can be performed. Accordingly, forward protrusion of the display 12 even in a case where the display 12 is displaced can be suppressed. Further, with such a configuration, as shown in FIG. 9, for example, the arms 14A and 14B can be displaced while suppressing protrusion of the main body 11 in the width direction by rotating the two rotation shafts AX1 and AX2 in opposite directions. Accordingly, a space required for the displacement mechanism 14 in accordance with the displacement of the display 12 can be reduced. In particular, as shown in (B) of FIG. 9, a case where a wall is disposed at the position of the imaginary line WL is advantageous.

In addition, in the embodiment, in the main body 11, the worktable 18 that can be used for work related to examination is provided below the display 12, the GUI operation section 20B is displayed on an end part side close to the worktable 18 on the display screen 20 displayed on the display 12, and the end part of the display 12 on the side where the GUI operation section 20B is displayed can be accommodated in the recess portion 16. For this reason, since the GUI operation section 20B can be disposed near the user ST, the hand of the user ST can easily reach the GUI operation section 20B, and operability is improved. Further, since there is an effect that the amount of movement of the line of sight of the user ST is reduced, workability is improved. In addition, with such a configuration, an effect of securing a suitable interval between the GUI operation section 20B and the user ST in front of the worktable 18 and improving the visibility of the GUI operation section 20B can also be expected.

The embodiment is merely an example, and various modifications can be made. For example, the posture change of the display 12 shown in FIGS. 6 to 10 is an example, and the posture can be changed to different postures depending on how the arms 14A and 14B are displaced. In addition, even in a case where the direction of the display surface 12A of the display 12 is the same, the position of the display 12 can also be changed by changing the postures of the arms 14A and 14B.

In addition, the two arm and two shaft displacement mechanism 14 having two arms and two rotation shafts has been described as an example in the embodiment, but a three or more arm and a three or more shaft displacement mechanism in which the number of arms is three or more and the number of rotation shafts is three or more may be used. In a case of the three or more arm and three or more shaft displacement mechanism, a degree of freedom of a posture change of the display 12 can be further improved. As the number of arms and the number of rotation shafts are increased in this manner, the degree of freedom of the posture change is improved, but there is a case where a disadvantage occurs. For example, in a case of the three or more arm and three or more shaft displacement mechanism, the configuration is complicated, the size is increased, and a required space for an operation of the displacement mechanism is increased in some cases. In a case where the displacement mechanism is disposed on the rear surface of the display 12, an increase in size of the displacement mechanism leads to an increase in the amount of forward protrusion of the display 12, resulting in an increase in the feeling of pressure given by the display 12. In addition, in a case where the number of rotation shafts is three or more, the movement of the arm is complicated, and the arm easily interferes with the bottom surface 16A of the recess portion 16 in some cases. In consideration of overall balance between the degree of freedom of the posture change of the display 12 and the size of the displacement mechanism and the like, the two arm and two shaft displacement mechanism 14 is preferable as in the embodiment in some cases.

In addition, the direction of the rotation shaft is not limited to the up-down direction (that is, the Z-direction) and may include a rotation shaft extending in the width direction (that is, the Y-direction). In addition, a universal joint or the like may be used instead of the rotation shaft. Accordingly, a degree of freedom of a posture change of the display 12 can be further improved. In addition, the direction of the horizontally long display surface 12A of the display 12 may be changed to a vertically long posture.

In addition, an example in which the displacement mechanism 14 is provided has been described in the embodiment, but the displacement mechanism 14 may not be provided, and for example, as shown in FIGS. 1 to 5, the display 12 may be fixed in a state where the one end part of the display 12 is accommodated in the recess portion 16. Even in this case, for example, since a suitable interval can be secured between the user ST positioned in front of the worktable 18 and the one end part of the display 12, an effect of reducing the feeling of pressure by the display 12 can be obtained.

In addition, for example, the immunoassay device with the chemiluminescent enzyme immunoassay as a basic principle is shown as the examination device 10 in the embodiment, but the examination device 10 is not limited thereto. The measuring method is not limited to chemiluminescent enzyme immunoassay, and immunoassay device may not be used. The present disclosed technology can be applied to various in vitro examination devices that examine a specimen outside a body.

The above description discloses technologies described in the following supplementary notes.

### Supplementary Note 1

An examination device that examines a specimen, the examination device comprising:
a display that is disposed on a front surface of a main body; and
a recess portion that is provided in the front surface of the main body and that is capable of accommodating one end part of the display in a width direction of the main body.

### Supplementary Note 2

The examination device according to supplementary note 1, further comprising:
a displacement mechanism that displaces the display.

### Supplementary Note 3

The examination device according to supplementary note 2,
wherein the displacement mechanism is capable of displacing the display in a state where the one end part of the display is accommodated in the recess portion.

### Supplementary Note 4

The examination device according to supplementary note 2 or 3,
wherein the displacement mechanism is capable of displacing the display to a state where an angle between a display surface of the display and a bottom surface of the recess portion is a preset angle in a range of 70° to 110°, on one end side of the recess portion in the width direction of the main body.

### Supplementary Note 5

The examination device according to supplementary note 4,
wherein the displacement mechanism is capable of displacing the display to a state where the angle is the preset angle without causing the display and the displacement mechanism to protrude from the range in the width direction of the main body.

### Supplementary Note 6

The examination device according to supplementary note 5,
wherein the preset angle includes 90°.

### Supplementary Note 7

The examination device according to any one of supplementary notes 2 to 6,
wherein the recess portion is capable of accommodating at least a part of the displacement mechanism.

### Supplementary Note 8

The examination device according to any one of supplementary notes 3 to 7,
wherein in the main body, a worktable that is usable in work related to examination is provided below the display.

### Supplementary Note 9

The examination device according to supplementary notes 2 to 8,
wherein in the main body, a worktable that is usable in work related to examination is provided below the display, and
the displacement mechanism is capable of retracting the display from the worktable by displacing the one end part of the display in the width direction of the main body, which is an end part on a worktable side, in a direction of being accommodated in the recess portion.

### Supplementary Note 10

The examination device according to supplementary note 9,
wherein the displacement mechanism is capable of changing a posture of the display such that a display surface of the display faces the worktable side in a state where the one end part is accommodated in the recess portion.

### Supplementary Note 11

The examination device according to supplementary note 8 or 9,
wherein a position of the recess portion and a position of the worktable partially overlap each other in the width direction of the main body.

### Supplementary Note 12

The examination device according to any one of supplementary notes 2 to 11,
wherein the displacement mechanism includes an arm that has one end provided at the main body and the other end supporting a rear surface of the display.

### Supplementary Note 13

The examination device according to supplementary note 12,
wherein the arm has two or more rotation shafts.

### Supplementary Note 14

The examination device according to supplementary note 13,
wherein the arm has at least two rotation shafts extending in an up-down direction of the main body.

### Supplementary Note 15

The examination device according to supplementary notes 1 to 14,
wherein in the main body, a worktable that is usable in work related to examination is provided below the display,
in a display screen displayed on the display, a GUI operation section is displayed on an end part side close to the worktable, and
the recess portion is capable of accommodating an end part of the display on a side where the GUI operation section is displayed.

The present disclosed technology can also be combined with various embodiments and/or various modification examples described above as appropriate. In addition, it is evident that the present disclosure is not limited to each of the embodiments, various configurations can be adopted without departing from the gist.

The above description and illustrations are detailed description of portions according to the present disclosed technology and are merely examples of the present disclosed technology. For example, the above description related to the configuration, the function, the operation, and the effect is description related to examples of the configuration, the function, the operation, and the effect of the portions according to the present disclosed technology. Therefore, it is evident that unnecessary portions may be deleted or new elements may be added or replaced in the above description and illustrations without departing from the gist of the present disclosed technology. In addition, in order to avoid complications and facilitate understanding of the portions according to the present disclosed technology, description related to common general knowledge and the like that do not require special description for enabling the implementation of the present disclosed technology is omitted in the above description and illustrations.

In the present specification, "A and/or B" is synonymous with "at least one of A or B". That is, "A and/or B" means that it may be only A, only B, or a combination of A and B. In addition, in the present specification, also in a case where three or more matters are expressed in association by "and/or", the same concept as "A and/or B" is applied.

All of the documents, the patent applications, and the technical standards described in the present specification are incorporated herein by reference to the same extent as in a case where each of the documents, patent applications, and technical standards is specifically and individually described by being incorporated by reference.

Explanation of References

## Claims

1. An examination device (10) that examines a specimen, the examination device comprising:
a display (12) that is disposed on a front surface of a main body (11); and
a recess portion (16) that is provided in the front surface of the main body and that is capable of accommodating one end part of the display in a width direction of the main body.

2. The examination device according to claim 1, further comprising:
a displacement mechanism (14) that displaces the display.

3. The examination device according to claim 2,
wherein the displacement mechanism (14) is capable of displacing the display (12) in a state where the one end part of the display is accommodated in the recess portion.

4. The examination device according to claim 2,
wherein the displacement mechanism (12) is capable of displacing the display to a state where an angle between a display surface of the display and a bottom surface of the recess portion is a preset angle in a range of 70° to 110°, on one end side of the recess portion in the width direction of the main body.

5. The examination device according to claim 4,
wherein the displacement mechanism (12) is capable of displacing the display to a state where the angle is the preset angle without causing the display and the displacement mechanism to protrude from the range in the width direction of the main body.

6. The examination device according to claim 5,
wherein the preset angle includes 90°.

7. The examination device according to claim 2,
wherein the recess portion (16) is capable of accommodating at least a part of the displacement mechanism.

8. The examination device according to claim 3,
wherein in the main body (11), a worktable (18) that is usable in work related to examination is provided below the display.

9. The examination device according to claim 2,
wherein in the main body (11), a worktable (18) that is usable in work related to examination is provided below the display, and
the displacement mechanism (12) is capable of retracting the display from the worktable by displacing the one end part of the display in the width direction of the main body, which is an end part on a worktable side, in a direction of being accommodated in the recess portion.

10. The examination device according to claim 9,
wherein the displacement mechanism (12) is capable of changing a posture of the display such that a display surface of the display faces the worktable side in a state where the one end part is accommodated in the recess portion.

11. The examination device according to claim 8,
wherein a position of the recess portion (16) and a position of the worktable (18) partially overlap each other in the width direction of the main body.

12. The examination device according to claim 2,
wherein the displacement mechanism (16) includes an arm (14A, 14B) that has one end provided at the main body and the other end supporting a rear surface of the display.

13. The examination device according to claim 12,
wherein the arm has two or more rotation shafts.

14. The examination device according to claim 13,
wherein the arm has at least two rotation shafts extending in an up-down direction of the main body.

15. The examination device according to claim 1,
wherein in the main body (11), a worktable that is usable in work related to examination is provided below the display,
in a display screen displayed on the display, a GUI operation section is displayed on an end part side close to the worktable, and
the recess portion is capable of accommodating an end part of the display on a side where the GUI operation section is displayed.
